(19) Europäisches Patentamt
European Patent Office
Office européen des brevets

(11) **EP 4 597 565 A1**

(12) **EUROPEAN PATENT APPLICATION**
published in accordance with Art. 153(4) EPC

(43) Date of publication:
**06.08.2025 Bulletin 2025/32**

(21) Application number: 23872333.2

(22) Date of filing: **26.09.2023**

(51) International Patent Classification (IPC):
*H01L 23/40* (2006.01)    *H01L 25/04* (2023.01)
*H01L 25/18* (2023.01)    *H05K 7/20* (2006.01)

(52) Cooperative Patent Classification (CPC):
**H01L 23/40; H01L 25/04; H01L 25/18; H05K 7/20**

(86) International application number:
**PCT/JP2023/034917**

(87) International publication number:
**WO 2024/071110 (04.04.2024 Gazette 2024/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.09.2022 JP 2022152741**

(71) Applicant: **Kyocera Corporation
Kyoto-shi, Kyoto 612-8501 (JP)**

(72) Inventors:
• **TSUJINO, Saki
Kyoto-shi, Kyoto 612-8501 (JP)**
• **AKAHOSHI, Tomoyuki
Kyoto-shi, Kyoto 612-8501 (JP)**
• **YAMAMOTO, Takashi
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **SEMICONDUCTOR MODULE**

(57)    A semiconductor module includes a substrate, at least one semiconductor element located on a first surface of the substrate, a heat dissipation member located above the semiconductor element, and an optical fiber cable connected to the semiconductor element. A first direction in which the heat dissipation member extends with respect to the semiconductor element intersects a second direction in which the optical fiber cable extends.

FIG. 4

EP 4 597 565 A1

## Description

TECHNICAL FIELD

Embodiments of the disclosure relate generally to a semiconductor module.

BACKGROUND OF INVENTION

There is a known a semiconductor module in which a semiconductor element (hereinafter, also called an optical element) configured to convert an electric signal into an optical signal is mounted on a substrate. An optical fiber cable configured to transmit a converted optical signal from the optical element to the outside may be connected to this semiconductor module (see Patent Document 1).

CITATION LIST

PATENT LITERATURE

Patent Document 1: JP 2020-9824 A

SUMMARY

A semiconductor module of the present disclosure includes a substrate, at least one semiconductor element located on a first surface of the substrate, a heat dissipation member located above the semiconductor element, and an optical fiber cable connected to the semiconductor element. A first direction in which the heat dissipation member extends with respect to the semiconductor element intersects a second direction in which the optical fiber cable extends.

BRIEF DESCRIPTION OF THE DRAWINGS

FIG. 1 is a perspective view of a semiconductor module according to an embodiment as viewed from diagonally above.

FIG. 2 is a perspective view of the semiconductor module according to the embodiment as viewed from diagonally below.

FIG. 3 is a plan view of the semiconductor module according to the embodiment.

FIG. 4 is a side view of the semiconductor module according to the embodiment.

FIG. 5 is a plan view of a semiconductor module according to another first embodiment.

FIG. 6 is a plan view of a semiconductor module according to another second embodiment.

FIG. 7 is a plan view of a semiconductor module according to another third embodiment.

FIG. 8 is a side view of the semiconductor module according to the other third embodiment.

FIG. 9 is a cross-sectional view taken along line A-A illustrated in FIG. 7 as viewed in the direction of arrows.

FIG. 10 is a perspective view of a semiconductor module according to another fourth embodiment as viewed from diagonally above.

FIG. 11 is a cross-sectional view taken along line B-B illustrated in FIG. 10 as viewed in the direction of arrows.

DESCRIPTION OF EMBODIMENTS

Hereinafter, embodiments of a semiconductor module disclosed in the present application will be described with reference to the accompanying drawings. Note that the present disclosure is not limited by the following embodiments. Embodiments can be appropriately combined as long as the processing contents do not contradict each other. In the following embodiments, the same portions are denoted by the same reference signs, and redundant descriptions are omitted.

In the following embodiments, expressions such as "certain", "orthogonal", "perpendicular", and "parallel" may be used, but these expressions need not mean exactly "certain", "orthogonal", "perpendicular", and "parallel". That is, each of the expressions described above allows for deviations in, for example, manufacturing accuracy, installation accuracy, and the like.

In each of the drawings, which will be referred to below, for ease of explanation, an X axis direction, a Y axis direction, and a Z axis direction that are orthogonal to one another may be defined to illustrate a rectangular coordinate system in which a Z axis positive direction is a vertically upward direction.

There is a known a semiconductor module in which a semiconductor element (hereinafter, also called an optical element) configured to convert an electric signal into an optical signal is mounted on a substrate. An optical fiber cable configured to transmit a converted optical signal from the optical element to the outside may be connected to this semiconductor module.

However, in the above-described known technology, heat distribution in the extending direction of the optical fiber cable may be non-uniform due to heat generated in various elements such as an optical element mounted on the semiconductor module. Thus, the signal quality of the optical signal transmitted in the optical fiber cable may deteriorate.

Therefore, there is a need for a technology that can overcome the above-described problems and improve the signal quality of the optical signal.

Embodiments

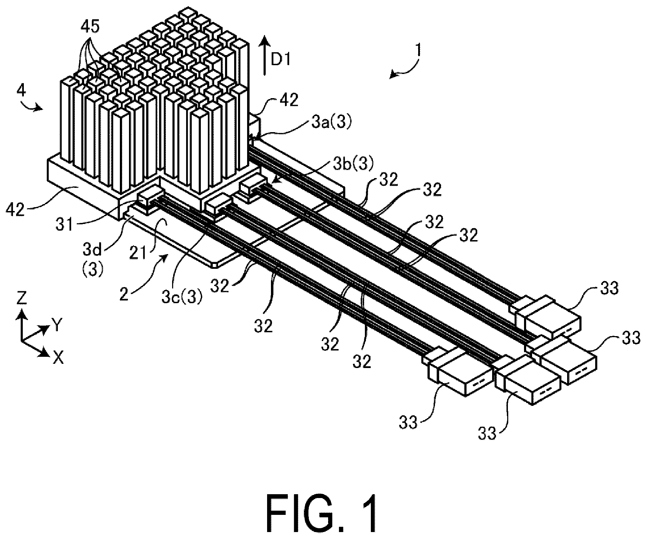

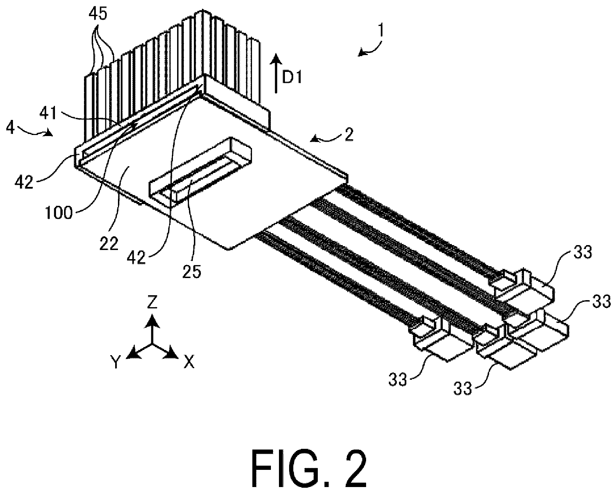

First, an overall configuration of a semiconductor module 1 according to an embodiment will be described with reference to FIGs. 1 and 2. FIG. 1 is a perspective view of the semiconductor module 1 according to the embodiment as viewed diagonally from above, and FIG. 2 is a perspective view of the semiconductor module 1 according to the embodiment as viewed obliquely from below.

Note that each embodiment described below will be described with an example of a case where the semiconductor module 1 is an optical module in which the optical element 3 is mounted on a substrate, but the semiconductor module according to the present disclosure is not necessarily required to be an optical module.

As illustrated in FIGs. 1 and 2, the semiconductor module 1 according to the embodiment includes a substrate 2, a plurality of optical elements 3 (optical elements 3a to 3d), and a heat dissipation member 4. The optical element 3 is an example of the semiconductor element.

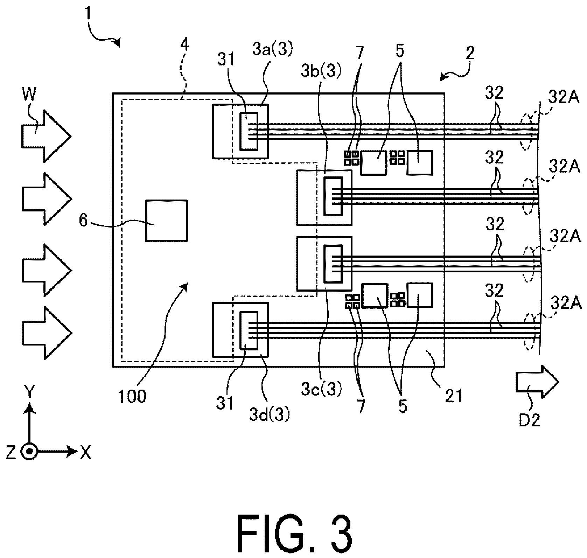

The substrate 2 has, for example, a quadrilateral plate shape in plan view. On a first surface 21 (here, upper surface) of the substrate 2, in addition to the plurality of optical elements 3a to 3d and the heat dissipation member 4, a power source IC 5, a control IC 6, a chip resistor 7 (see FIG. 3 for all), and the like are located. A capacitor, a coil, and the like not illustrated may be located on the first surface 21 of the substrate 2.

A connector 25 is located on a second surface 22 (here, lower surface) of the substrate 2. The substrate 2 is electrically connected to a motherboard via the connector 25.

The optical element 3 is a semiconductor element configured to convert an electric signal into an optical signal. The optical element 3 may convert an optical signal into an electric signal. An interface 31 is located on the upper surface of each of the optical elements 3. The interface 31 is connected to an optical connector 33 via a cable group 32A (see FIG. 3) including a plurality of optical fiber cables 32. Hereinafter, the optical fiber cable 32 may also refer to the cable group 32A based on the corresponding drawing.

The heat dissipation member 4 is what is called a heat sink, and is located above the plurality of optical elements 3. Note that the heat dissipation member 4 need not cover all of the plurality of optical elements 3 from above. That is, as illustrated in FIG. 1, the upper surfaces of the plurality of optical elements 3 may be partially exposed from the heat dissipation member 4.

The heat dissipation member 4 is close to the plurality of optical elements 3 and dissipates heat generated from the optical elements 3 to the outside of the semiconductor module 1. Note that the heat dissipation member 4 may be in direct contact with the optical element 3. Alternatively, the heat dissipation member 4 may be in contact with the optical element 3 via a thermal interface material (TIM). That is, the heat dissipation member 4 may be thermally connected to the plurality of optical elements 3.

The heat dissipation member 4 may be made of a metal having relatively high thermal conductivity, such as aluminum, copper, or iron. TIM is a composite material containing a thermally conductive filler in a resin.

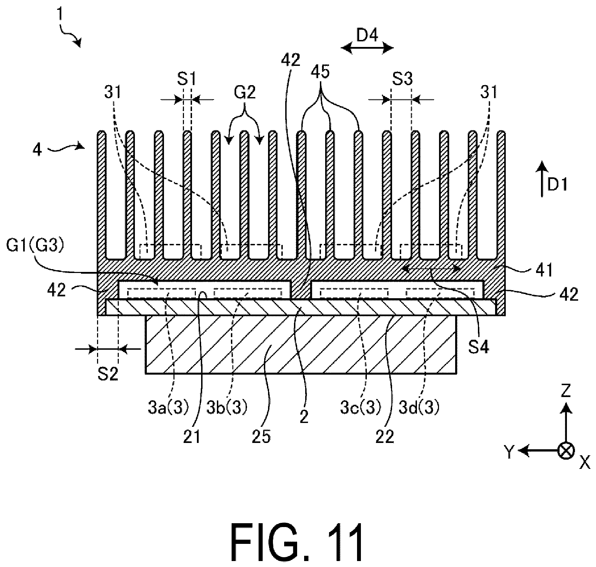

The heat dissipation member 4 includes a first portion 41, a plurality of third portions 42, and a plurality of second portions 45. The first portion 41 is a plate-like portion arranged to face the first surface 21 of the substrate 2 with a first gap G1 therebetween (see FIG. 11).

The plurality of third portions 42 are leg-like portions provided in the first portion 41. Specifically, the third portion 42 extends from the first portion 41 toward the substrate 2 and comes into contact with the substrate 2 (is placed on the substrate 2). The plurality of third portions 42 are separated from each other by a third gap G3 (see FIG. 11) along a fourth direction D4 (see FIG. 11).

These third portions 42 have a shape whose thickness is partially thicker from the first portion 41. The third portion 42 may be integrated with the first portion 41. The plurality of third portions 42 may be connected to the first portion 41 and the substrate 2. The plurality of third portions 42 extend in a certain direction (here, X axis direction).

The second portion 45 is a portion located on the surface of the first portion 41 opposite to the surface facing the substrate 2, the portion extending from the first portion 41 along a first direction D1. Although FIGs. 1 and 2 illustrate an example in which the second portion 45 has a pin shape (i.e., a case of a heat dissipation pin), the second portion 45 may have, for example, a plate shape (i.e., a heat dissipation fin).

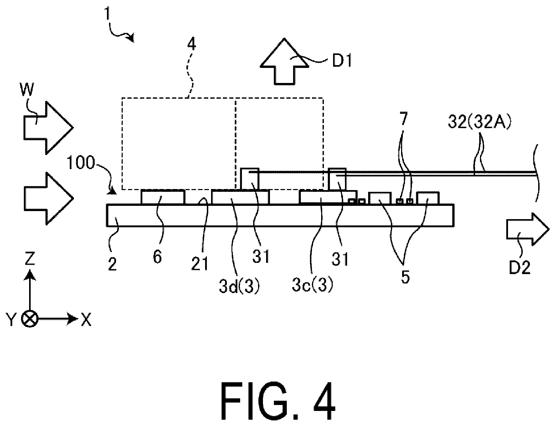

A detailed configuration of the semiconductor module 1 according to the embodiment will be described with reference to FIGs. 3 and 4. FIG. 3 is a plan view of the semiconductor module 1 according to the embodiment, and FIG. 4 is a side view of the semiconductor module 1 according to the embodiment. Note that in FIGs. 3 and 4, the heat dissipation member 4 is indicated by a broken line for easy understanding.

As illustrated in FIG. 4 and the like, the first direction D1 in which the heat dissipation member 4 extends with respect to the optical element 3 is the Z axis positive direction. That is, the first direction D1 in which the heat dissipation member 4 dissipates heat is the Z axis positive direction. On the other hand, a second direction D2 in which the optical fiber cable 32 extends from the optical element 3 is an X axis positive direction.

That is, in the embodiment, the first direction D1 in which the heat dissipation member 4 extends with respect to the optical element 3 and the second direction D2 in which the optical fiber cable 32 extends may intersect. Thus, the heat generated in the optical element 3 can be dissipated in a direction away from the optical fiber cable 32, and therefore the temperature distribution in the extending direction of the optical fiber cable 32 can be made uniform.

Therefore, according to the embodiment, since deterioration of the signal quality due to non-uniformity of the temperature distribution in the optical fiber cable 32 can be prevented, the signal quality of the optical signal can be improved.

In the embodiment, as illustrated in FIG. 4, the cable group 32A is preferably arranged and includes a part parallel with the first surface 21 above the substrate 2. A part parallel to the substrate 2 of the cable group 32A is preferably located on the optical element 3 side to which the cable group 32A is connected in the cable group 32A.

The cable group 32A may be gradually curved in a direction from the optical element 3 side to which the cable group 32A is connected to the end portion side of the substrate 2 in the direction in which the cable group 32A extends. For example, near the end portion of the substrate 2, the cable group 32A may be partially bent and approach the first surface 21 of the substrate 2 or come into contact with the first surface 21 of the substrate 2.

The cable group 32A may have an orientation directed away from the first surface 21 of the substrate 2 near the end portion of the substrate 2. This is because the orientation varies in relation to the arrangement and height of an external circuit device to which the cable group 32A is connected.

The optical fiber cable 32 (or the cable group 32A) may be parallel with the first surface 21 at least above the substrate 2. Thus, the temperature distribution in the extending direction of the optical fiber cable 32 (or the cable group 32A) can be further made uniform.

In this case, the optical fiber cable 32 (or the cable group 32A) preferably extends in parallel with the first surface 21 of the substrate 2 in the entire range from the connection portion with the optical element 3 above the substrate 2 to the end portion of the substrate 2.

This is because when a part of the optical fiber cable 32 (or the cable group 32A) is bent above the substrate 2, the airflow (heat) hitting the bent part tends to be turbulent, and the heat dissipation tends to be hindered.

Therefore, according to the embodiment, the signal quality of the optical signal can be further improved.

As illustrated in FIG. 3, the plurality of optical elements 3a to 3d are arranged along a direction (Y axis direction) orthogonal to the extending direction (X axis direction) of the optical fiber cable 32 when viewed along the extending direction. Specifically, the plurality of optical elements 3a to 3d are arranged in a Y axis positive direction in order of the optical element 3d, the optical element 3c, the optical element 3b, and the optical element 3a.

The plurality of optical elements 3a to 3d are located away from one another. This configuration can reduce thermal interference among the optical elements 3a to 3d when the plurality of optical elements 3a to 3d are located on the substrate 2.

When a plurality of devices such as the optical elements 3a to 3d, which are heat sources, are arranged on the same substrate, if the distance among the optical elements 3a to 3d is short, the heat generated by the individual optical elements 3a to 3d is synergized, and the temperature of the optical elements 3a to 3d may become higher than that at the time of use alone.

Arrangement of the plurality of optical elements 3a to 3d separately as illustrated in FIG. 3 can suppress the heat generated by the individual optical elements 3a to 3d from being synergistically increased. Arranging the power source IC 5 and the chip resistor 7 between the optical fiber cables 32 naturally increases the gaps between the optical elements 3a to 3d.

Specifically, as illustrated in FIG. 3, the optical element 3a of the plurality of optical elements 3a to 3d and the optical element 3b located closest to the optical element 3a are shifted in position from each other in the extending direction (X axis direction) of the optical fiber cable 32 and the direction (Y axis direction) orthogonal to the extending direction. In a same or similar manner, among the plurality of optical elements 3a to 3d, the optical element 3d and the optical element 3c located closest to this optical element 3d are shifted in position from each other in the X axis direction and the Y axis direction.

In this manner, the plurality of optical elements 3 are arranged to be shifted from one another. Thus, in the embodiment, the size of the substrate 2 can be reduced while securing the distance between the adjacent optical elements 3, in other words, while suppressing thermal interference between the adjacent optical elements 3.

Here, an example of a case where two adjacent optical elements (e.g., the optical element 3a and the optical element 3b) of the plurality of optical elements 3a to 3d are separated in the X axis direction and the Y axis direction has been described. However, the present disclosure is not limited to this, and in all of the plurality of optical elements 3a to 3d, the positions of two adjacent semiconductor elements may be shifted in the extending direction (X axis direction) of the optical fiber cable 32 and the direction (Y axis direction) orthogonal to the extending direction.

For example, the plurality of optical elements 3a to 3d may be alternately arranged. This also can reduce the size of the substrate 2 while suppressing thermal interference among the optical elements 3.

A blower (not illustrated) such as a cooling fan that sends air to the semiconductor module 1 may be located on an X axis negative direction side of the semiconductor module 1. Such a blower generates and sends wind W in the X axis positive direction.

The wind W sent from the blower hits the plurality of second portions 45 (see FIG. 1) and flows along the first surface 21 of the substrate 2 and passes through an air passage 100 formed between the substrate 2 and the first portion 41 of the heat dissipation member 4.

In the embodiment, the wind W hits the plurality of optical elements 3 located on the outlet side of the air passage 100, whereby the heat dissipation efficiency of the plurality of optical elements 3 can be further enhanced.

In the embodiment, since the plurality of optical elements 3 are arranged along the direction (here, the Y axis direction) intersecting the direction in which the wind W flows, the wind W substantially uniformly hits all the optical elements 3. Therefore, according to the embodiment, the heat dissipation efficiency of the plurality of optical elements 3 can be further enhanced.

As illustrated in FIG. 3, the control IC 6 may be located below the heat dissipation member 4. The control IC 6 may be thermally connected to the heat dissipation member 4. Thus, the heat generated from the control IC 6 can be efficiently dissipated by the heat dissipation member 4.

For example, a plurality of (four in FIG. 3) power source ICs 5 may be located on the substrate 2. This can supply the optical element 3 with electric power at a plurality of types (four types in FIG. 3) of reference voltages.

The power source IC 5 may be located on the opposite side of the control IC 6 with reference to the optical element 3 in plan view of the first surface 21. For example, the control IC 6 may be located on the X axis negative direction side of the optical element 3, and the power source IC 5 may be located on the X axis positive direction side of the optical element 3.

This can reduce interference between the power source IC 5 and various wirings (not illustrated) located between the control IC 6 and the optical element 3 on the first surface 21 side of the substrate 2. Therefore, according to the embodiment, the degree of freedom in wiring design can be secured.

The plurality of chip resistors 7 may be located close to the corresponding power source IC 5. That is, the plurality of chip resistors 7 may be located on the opposite side of the control IC 6 with the optical element 3 as a reference in plan view of the first surface 21.

In the embodiment, as illustrated in FIG. 3, the power source IC 5 and/or the chip resistor 7 may be located at a place adjacent to the optical fiber cable 32 and not overlapping the optical fiber cable 32 in plan view of the first surface 21.

The power source IC 5 and/or the chip resistor 7 is preferably located at a place not overlapping the optical element 3 also in the X axis direction in plan view of the first surface 21.

Both the power source IC 5 and the chip resistor 7 are preferably located at places not overlapping the optical element 3 as viewed in the X axis direction in plan view of the first surface 21.

For example, the power source IC 5 and/or the chip resistor 7 may be located between the cable groups 32A adjacent to each other in plan view of the first surface 21.

This can reduce a local temperature rise of the optical fiber cable 32 due to the heat generated from the power source IC 5 and/or the chip resistor 7. That is, in the embodiment, the temperature distribution in the extending direction of the optical fiber cable 32 can be made uniform.

Therefore, according to the embodiment, the signal quality of the optical signal can be improved.

In the embodiment, either the power source IC 5 or the chip resistor 7 may be located at a place not overlapping the optical fiber cable 32, or both the power source IC 5 and the chip resistor 7 may be located at places not overlapping the optical fiber cable 32.

Since both the power source IC 5 and the chip resistor 7 are located at places not overlapping the optical fiber cable 32, the local temperature rise of the optical fiber cable 32 can be further reduced. Therefore, according to the embodiment, the signal quality of the optical signal can be further improved.

Other First Embodiment

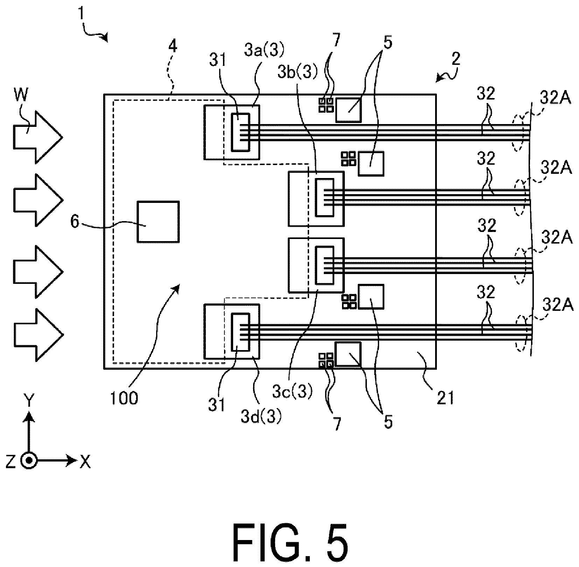

Next, the semiconductor module 1 according to other various embodiments will be described with reference to FIGs. 5 to 11. FIG. 5 is a plan view of the semiconductor module 1 according to the other first embodiment.

As illustrated in FIG. 5, in the other first embodiment, the arrangement of the power source IC 5 and the chip resistor 7 is different from that of the above-described embodiment. Specifically, in the other first embodiment, all the optical elements 3 and all the power source ICs 5 may be located at places not interfering with each other with respect to the wind W sent along the first surface 21 of the substrate 2 from the outside.

Thus, all the optical elements 3 and all the power source ICs 5 can be efficiently cooled by the wind W.

In the other first embodiment, the chip resistor 7 may be located windward of the corresponding power source IC 5 with respect to the wind W sent along the first surface 21 of the substrate 2 from the outside.

Thus, wind W can be hit to both the chip resistor 7 and the power source IC 5 taller than the chip resistor 7. Therefore, according to the other first embodiment, all the power source ICs 5 and all the chip resistors 7 can be efficiently cooled by the wind W.

In the other first embodiment, all the power source ICs 5 and all the chip resistors 7 are efficiently cooled by the wind W, whereby the local temperature rise of the optical fiber cable 32 due to the heat generated from the power source IC 5 and the chip resistors 7 can be reduced.

That is, in the other first embodiment, the temperature distribution in the extending direction of the optical fiber cable 32 can be made uniform. Therefore, according to the other first embodiment, the signal quality of the optical signal can be improved.

The width of the power source IC 5 is preferably wider than the width of the chip resistor 7. Here, the width refers to a length in a direction parallel to the first surface 21 of the substrate 2. In FIG. 5, it is the length in the Y axis direction.

If the width of the power source IC 5 is larger (wider) than the width of the chip resistor 7 between the power source IC 5 and the chip resistor 7, when the power source IC 5 and the chip resistor 7 are arranged in the direction in which the wind W flows (in this case, the X axis direction) on the substrate 2, the power source IC 5 having a large width may be arranged at the rear of the chip resistor 7.

This is because the power source IC 5 having a wide width includes a part protruding beyond the width of the chip resistor 7, and therefore the wind W easily hits the power source IC 5 even partially even if the power source IC 5 is arranged on the lower side in the flowing direction of the wind W at the rear of the chip resistor 7.

One of the height (thickness) and the width of the power source IC 5 may be larger than that of the chip resistor 7, but both the height (thickness) and the width may be larger.

Other Second Embodiment

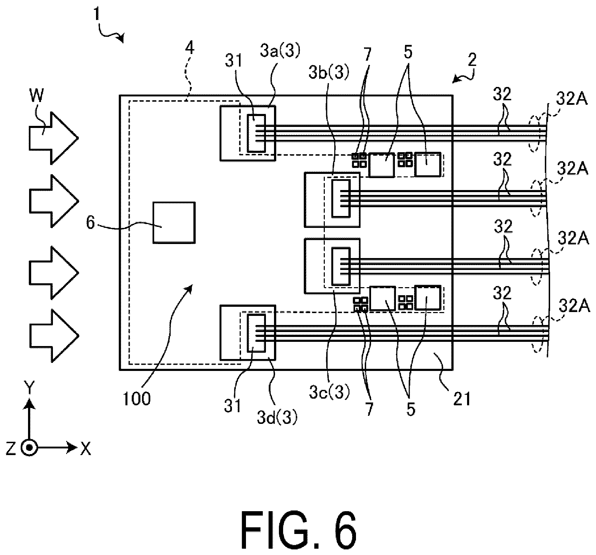

FIG. 6 is a plan view of a semiconductor module 1 according to the other second embodiment. As illustrated in FIG. 6, in the other second embodiment, the configuration of the heat dissipation member 4 is different from that of the above-described embodiments. Specifically, in the other second embodiment, the heat dissipation member 4 may be located above the power source IC 5 and the chip resistor 7 in addition to being located above the optical element 3 and the control IC 6.

In the other second embodiment, the power source IC 5 and/or the chip resistor 7 may be thermally connected to the heat dissipation member 4. Thus, heat generated from the power source IC 5 and/or the chip resistor 7 can be efficiently dissipated by the heat dissipation member 4.

In the other second embodiment, the power source IC 5 and/or the chip resistor 7 is thermally connected to the heat dissipation member 4, whereby a local temperature rise of the optical fiber cable 32 due to the heat generated from the power source IC 5 and/or the chip resistor 7 can be reduced.

That is, in the other second embodiment, the temperature distribution in the extending direction of the optical fiber cable 32 can be made uniform. Therefore, according to the other second embodiment, the signal quality of the optical signal can be improved.

In the other second embodiment, either the power source IC 5 or the chip resistor 7 may be thermally connected to the heat dissipation member 4, or both the power source IC 5 and the chip resistor 7 may be thermally connected to the heat dissipation member 4.

Both the power source IC 5 and the chip resistor 7 are thermally connected to the heat dissipation member 4, whereby the heat generated from both the power source IC 5 and the chip resistor 7 can be efficiently dissipated by the heat dissipation member 4.

Other Third Embodiment

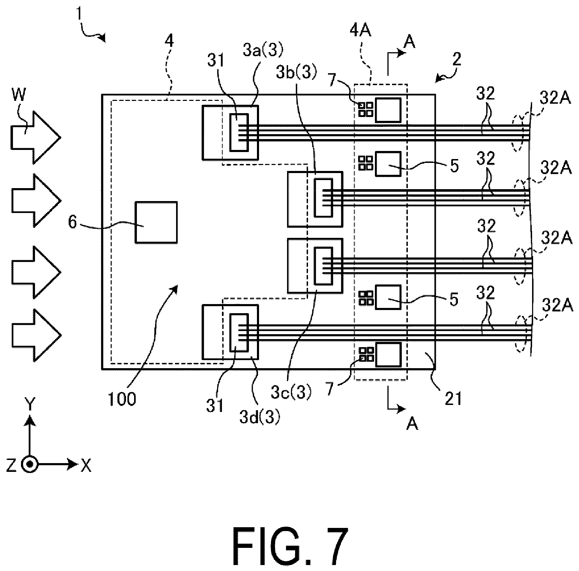

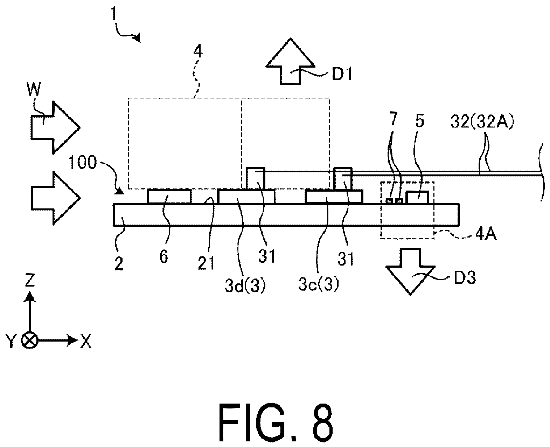

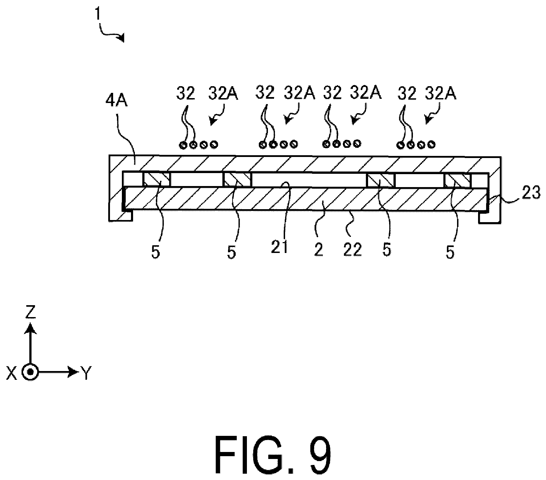

FIG. 7 is a plan view of the semiconductor module 1 according to the other third embodiment, and FIG. 8 is a side view of the semiconductor module 1 according to the other third embodiment. FIG. 9 is a cross-sectional view taken along line A-A illustrated in FIG. 7 as viewed in the direction of arrows.

As illustrated in FIG. 7, in the other third embodiment, another heat dissipation member 4A in addition to the heat dissipation member 4 may be provided at the semiconductor module 1. The other heat dissipation member 4A may be made of a metal having relatively high thermal conductivity, such as aluminum, copper, or iron.

As illustrated in FIG. 7, the other heat dissipation member 4A may be disposed on the power source IC 5 and the chip resistor 7. As illustrated in FIG. 9, the other heat dissipation member 4A may be located around the peripheral portion of the second surface 22 from above the first surface 21 of the substrate 2 via a side surface 23 of the substrate 2.

In the other third embodiment, the power source IC 5 and/or the chip resistor 7 may be thermally connected to the other heat dissipation member 4A. Thus, the heat generated from the power source IC 5 and/or the chip resistor 7 can be efficiently dissipated by the other heat dissipation member 4A.

The power source IC 5 and/or the chip resistor 7 is thermally connected to the other heat dissipation member 4A, whereby a local temperature rise of the optical fiber cable 32 due to the heat generated from the power source IC 5 and/or the chip resistor 7 can be reduced.

That is, in the other third embodiment, the temperature distribution in the extending direction of the optical fiber cable 32 can be made uniform. Therefore, according to the other third embodiment, the signal quality of the optical signal can be improved.

In the other third embodiment, as illustrated in FIG. 8, a third direction D3 in which the other heat dissipation member 4A dissipates heat may be in an orientation different from the first direction D1 in which the heat dissipation member 4 dissipates heat. For example, the first direction D1 in which the heat dissipation member 4 dissipates heat may be the Z axis positive direction, and the third direction D3 in which the other heat dissipation member 4A dissipates heat may be a Z axis negative direction.

This can more efficiently cool the optical element 3, the power source IC 5, the control IC 6, and the chip resistor 7 located on the first surface 21 of the substrate 2.

In the other third embodiment, the third direction D3 in which the other heat dissipation member 4A dissipates heat is directed toward the second surface 22 side of the substrate 2 whereby a local temperature rise of the optical fiber cable 32 due to the heat generated from the power source IC 5 and/or the chip resistor 7 can be reduced.

That is, in the other third embodiment, the temperature distribution in the extending direction of the optical fiber cable 32 can be made uniform. Therefore, according to the other third embodiment, the signal quality of the optical signal can be improved.

In the other third embodiment, as illustrated in FIG. 9, the other heat dissipation member 4A and the optical fiber cable 32 may be separated from each other. Thus, heat transfer from the other heat dissipation member 4A to the optical fiber cable 32 can be reduced, and therefore the temperature distribution in the extending direction of the optical fiber cable 32 can be made uniform.

Therefore, according to the other third embodiment, the signal quality of the optical signal can be improved.

Note that in the other third embodiment, a heat insulating member may be located between the other heat dissipation member 4A and the optical fiber cable 32. This also can reduce heat transfer from the other heat dissipation member 4A to the optical fiber cable 32.

In the other third embodiment, as illustrated in FIG. 9, the other heat dissipation member 4A may have a substantial C shape in cross-sectional view. Thus, the other heat dissipation member 4A can be fixed to the substrate 2 with the other heat dissipation member 4A being fitted from above the substrate 2.

Therefore, according to the other third embodiment, the other heat dissipation member 4A can be easily attached to the substrate 2.

Other Fourth Embodiment

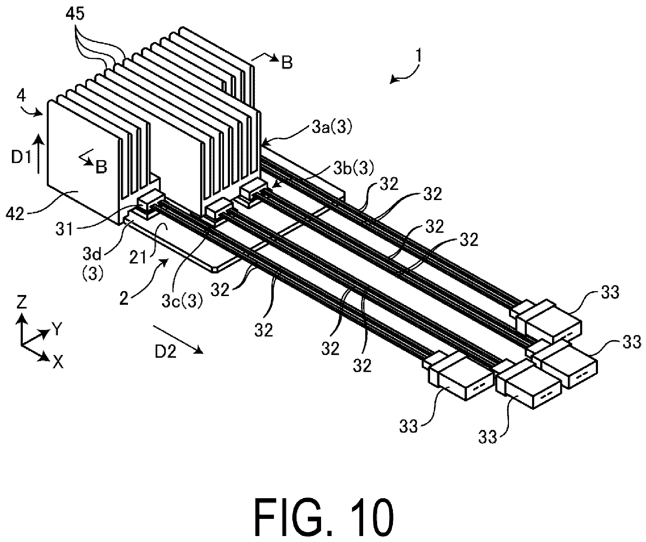

FIG. 10 is a perspective view of the semiconductor module 1 according to the other fourth embodiment as viewed diagonally above, and FIG. 11 is a cross-sectional view taken along line B-B illustrated in FIG. 10 as viewed in the direction of arrows.

As illustrated in FIGs. 10 and 11, in the other fourth embodiment, the configuration of the second portion 45 in the heat dissipation member 4 is different from that of the above-described embodiments (see FIG. 1). Specifically, in the other fourth embodiment, the second portion 45 may be a heat dissipation fin having a plate shape extending from the first portion 41 along the first direction D1.

In the other fourth embodiment, for example, as illustrated in FIG. 11, the plurality of second portions 45 are separated from each other by a second gap G2 along the fourth direction D4 (e.g., the Y axis direction) intersecting the second direction D2 (see FIG. 10).

Thus, as compared with the case where the second portion 45 is a heat dissipation pin, a dimension S1 in the fourth direction D4 of the second portion 45 can be reduced, and therefore the weight of the heat dissipation member 4 can be reduced.

In the other fourth embodiment, as illustrated in FIG. 10, the second gap G2 (see FIG. 11) between the adjacent second portions 45 may extend along the second direction D2. Thus, since the wind W (see FIG. 3) sent from the blower (not illustrated) flows smoothly along the second gap G2, the wind W substantially uniformly hits all the second portions 45.

Therefore, according to the other fourth embodiment, the heat dissipation efficiency of the heat dissipation member 4 can be further enhanced.

In the other fourth embodiment, as illustrated in FIG. 11, the dimension S1 in the fourth direction D4 of the second portion 45 may be smaller than a dimension S2 in the fourth direction D4 of the third portion 42. In this manner, reducing the dimension S1 of the second portion 45 (i.e., thinning the second portion 45) can achieve desired heat dissipation efficiency even if the heat dissipation member 4 is reduced in size and height.

That is, in the other fourth embodiment, the dimension S1 of the second portion 45 is made smaller than the dimension S2 of the third portion 42, whereby the thickness of the third portion 42 can be secured and the heat dissipation member 4 can be stably fixed to the substrate 2, and reduction in size and height of the heat dissipation member 4 can be achieved by thinning the second portion 45. Note that in the present disclosure, the dimension S1 in the fourth direction D4 of the second portion 45 may be, for example, 0.5 mm to 1.0 mm, more specifically, about 0.6 mm. The dimension S2 of the third portion 42 may be, for example, equal to or greater than 1 mm.

In the other fourth embodiment, when the dimension in the fourth direction D4 of the second gap G2 is S3, a dimension S4 in the fourth direction D4 of the interface 31 may satisfy the following Formula (1).

$$S4 \geq 2 \times S1 + 2 \times S3 \ ... \ (1)$$

In other words, with reference to the dimension S4 in the fourth direction D4 of the interface 31, the dimension of the heat dissipation member 4 may be defined and not only the thickness (i.e., the dimension S1) of the second portion 45 but also the pitch (i.e., dimension S3) of the plurality of second portions 45 are reduced.

Thus, since the number of the second portions 45 that can be arranged on the upper surface of the first portion 41 can be increased, the heat dissipation efficiency of the heat dissipation member 4 can be further enhanced. Since desired heat dissipation efficiency can be achieved even if the heat dissipation member 4 is reduced in size and height, reduction in size and height of the heat dissipation member 4 can be achieved.

Although embodiments of the present disclosure have been described above, the present disclosure is not limited to the embodiments described above, and various changes can be made without departing from the spirit of the present disclosure.

Additional effects and other aspects can be easily derived by a person skilled in the art. Accordingly, a wide variety of aspects of the present disclosure is not limited to the specific details and representative embodiments represented and described above. Therefore, various changes are possible without departing from the spirit or scope of the general inventive concepts defined by the appended claims and their equivalents.

Note that the present technology can also have the following configurations.

(1) A semiconductor module including:

a substrate;
at least one semiconductor element located on a first surface of the substrate;
a heat dissipation member located above the at least one semiconductor element; and
an optical fiber cable connected to the at least one semiconductor element; and
in which a first direction in which the heat dissipation member extends with respect to the at least one semiconductor element and a second direction in which the optical fiber cable extends intersect each other.

(2) The semiconductor module according to the (1), in which
the optical fiber cable includes a part parallel to the first surface at least above the substrate.

(3) The semiconductor module according to the (1) or (2) further including:

at least one power source IC located on the first surface and configured to supply the semiconductor element with electric power; and
at least one chip resistor located on the first surface and electrically connected to the power source IC,
in which the power source IC and/or the chip resistor is located at a place adjacent to the optical fiber cable and not overlapping the optical fiber cable in plan view of the first surface.

(4) The semiconductor module according to the (3), in which
the semiconductor element and the power source IC are located at places where the semiconductor element and the power source IC do not interfere with each other with respect to wind sent from outside along the first surface of the substrate.

(5) The semiconductor module according to the (3) or (4), in which
the chip resistor is located windward of the power source IC with respect to wind sent from outside along the first surface of the substrate.

(6) The semiconductor module according to any one of the (3) to (5), in which the power source IC and/or the chip resistor is thermally connected to the heat dissipation member.

(7) The semiconductor module according to any one of the (3) to (5), in which the power source IC and/or the chip resistor is thermally connected to another heat dissipation member.

(8) The semiconductor module according to the (7), in which
a third direction in which the other heat dissipation member dissipates heat is a direction different from the first direction.

(9) The semiconductor module according to any one of the (1) to (8), in which the heat dissipation member includes at least a first portion having a plate shape separated from the substrate by a first gap and facing the substrate, and a plurality of second portions extending from the first portion along the first direction, and
the second portion is a heat dissipation fin having a plate shape extending along the first direction.

(10) The semiconductor module according to the (9), in which

the plurality of second portions are separated from each other by a second gap along a fourth direction intersecting the second direction, and
the second gap extends along the second direction.

(11) The semiconductor module according to the (10), in which

the heat dissipation member further includes a plurality of third portions extending from the first portion toward the substrate, coming into contact with the substrate, and separated from each other by a third gap along the fourth direction, and
a dimension in the fourth direction of the second portion is smaller than a dimension in the fourth direction of the third portion.

REFERENCE SIGNS

1 Semiconductor module

2 Substrate
21 First surface
3, 3a to 3d Optical element (example of semiconductor element)
32 Optical fiber cable
4 Heat dissipation member
41 First portion
42 Third portion
45 Second portion
4A Other heat dissipation member
5 Power source IC
6 Control IC
7 Chip resistor
D1 First direction
D2 Second direction
D3 Third direction
D4 Fourth direction
G1 First gap
G2 Second gap
G3 Third gap
S1 to S4 Dimension
W Wind

## Claims

1. A semiconductor module comprising:

   a substrate;
   at least one semiconductor element located on a first surface of the substrate;
   a heat dissipation member located above the at least one semiconductor element; and
   an optical fiber cable connected to at least one of the semiconductor element, wherein
   a first direction in which the heat dissipation member extends with respect to the at least one semiconductor element and a second direction in which the optical fiber cable extends intersect each other.

2. The semiconductor module according to claim 1, wherein
   the optical fiber cable comprises a part parallel to the first surface at least above the substrate.

3. The semiconductor module according to claim 1 or 2 further comprising:

   at least one power source IC located on the first surface and configured to supply the at least one semiconductor element with electric power; and
   at least one chip resistor located on the first surface and electrically connected to the power source IC, wherein
   the power source IC and/or the chip resistor is located at a place adjacent to the optical fiber cable and not overlapping the optical fiber cable in plan view of the first surface.

4. The semiconductor module according to claim 3, wherein
   the semiconductor element and the power source IC are located at places where the semiconductor element and the power source IC do not interfere with each other with respect to wind sent from outside along the first surface of the substrate.

5. The semiconductor module according to claim 3 or 4, wherein
   the chip resistor is located windward of the power source IC with respect to wind sent from outside along the first surface of the substrate.

6. The semiconductor module according to any one of claims 3 to 5, wherein
   the power source IC and/or the chip resistor is thermally connected to the heat dissipation member.

7. The semiconductor module according to any one of claims 3 to 5, wherein
   the power source IC and/or the chip resistor is thermally connected to another heat dissipation member.

8. The semiconductor module according to claim 7, wherein
   a third direction in which the other heat dissipation member dissipates heat is a direction different from the first direction.

9. The semiconductor module according to any one of claims 1 to 8, wherein

   the heat dissipation member comprises at least a first portion having a plate shape separated from the substrate by a first gap and facing the substrate, and a plurality of second portions extending from the first portion along the first direction, and
   the second portion is a heat dissipation fin having a plate shape extending along the first direction.

10. The semiconductor module according to claim 9, wherein

    the plurality of second portions are separated from each other by a second gap along a fourth direction intersecting the second direction, and
    the second gap extends along the second direction.

11. The semiconductor module according to claim 10, wherein

**EP 4 597 565 A1**

the heat dissipation member further comprises a plurality of third portions extending from the first portion toward the substrate, coming into contact with the substrate, and separated from each other by a third gap along the fourth direction, and

a dimension in the fourth direction of the second portion is smaller than a dimension in the fourth direction of the third portion.

FIG. 1

FIG. 2

FIG. 3

FIG. 4

FIG. 5

FIG. 6

FIG. 7

FIG. 8

FIG. 9

# FIG. 10

FIG. 11

## INTERNATIONAL SEARCH REPORT

International application No.

**PCT/JP2023/034917**

### A. CLASSIFICATION OF SUBJECT MATTER

***H01L 23/40***(2006.01)i; ***H01L 25/04***(2023.01)i; ***H01L 25/18***(2023.01)i; ***H05K 7/20***(2006.01)i
FI: H01L23/40 A; H01L25/04 Z; H05K7/20 B

According to International Patent Classification (IPC) or to both national classification and IPC

### B. FIELDS SEARCHED

Minimum documentation searched (classification system followed by classification symbols)

H01L23/40; H05K7/20; H01L25/04; H01L25/18

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2014-178383 A (HITACHI METALS LTD) 25 September 2014 (2014-09-25) paragraphs [0001]-[0052], fig. 1, 2 | 1-2, 9-11 |
| A | entire text, all drawings | 3-8 |
| A | JP 2016-031990 A (HITACHI METALS LTD) 07 March 2016 (2016-03-07) entire text, all drawings | 1-11 |
| A | JP 2015-084040 A (HITACHI METALS LTD) 30 April 2015 (2015-04-30) entire text, all drawings | 1-11 |
| A | JP 2005-064384 A (TOSHIBA CORP) 10 March 2005 (2005-03-10) entire text, all drawings | 1-11 |
| A | JP 2010-211157 A (HITACHI CABLE LTD) 24 September 2010 (2010-09-24) entire text, all drawings | 1-11 |
| A | JP 2001-007403 A (NEC CORP) 12 January 2001 (2001-01-12) entire text, all drawings | 1-11 |

☐ Further documents are listed in the continuation of Box C.    ☑ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 December 2023** | **19 December 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2023/034917**

| Patent document cited in search report | | | Publication date (day/month/year) | Patent family member(s) | Publication date (day/month/year) |
|---|---|---|---|---|---|
| JP | 2014-178383 | A | 25 September 2014 | (Family: none) | |
| JP | 2016-031990 | A | 07 March 2016 | (Family: none) | |
| JP | 2015-084040 | A | 30 April 2015 | (Family: none) | |
| JP | 2005-064384 | A | 10 March 2005 | US        2005/0231911        A1 entire text, all drawings | |
| JP | 2010-211157 | A | 24 September 2010 | (Family: none) | |
| JP | 2001-007403 | A | 12 January 2001 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020009824 A